# EUROPEAN PATENT APPLICATION

(11) **EP 2 801 722 A1**
(43) Date of publication of application: **12.11.2014**
(21) Application number: 12863592.7
(22) Date of filing: 14.09.2012
(51) Int. Cl.: F03G 6/00, F03G 6/06, F24J 2/04, F24J 2/10, H01L 31/042, H01L 31/052

(54) **SOLAR LIGHT-HEAT HYBRID POWER GENERATION SYSTEM**

(30) Priority: 28.12.2011 JP 2011289109
(71) Applicant: Nitto Denko Corporation, Ibaraki-shi, Osaka 567-8680 (JP)
(72) Inventor: MATSUSHIMA, Ryoichi, (JP)
(74) Representative: Intès, Didier Gérard André
(86) International application number: PCT/JP2012/073615
(87) International publication number: WO 2013/099370

(57) **Abstract**

A solar light-heat hybrid power generation system having an improved efficiency is provided. A solar light-heat hybrid power generation system (100) that performs power generation by use of sunlight (52) and solar heat (52) includes a light collecting mirror (10) having an infrared reflective film (20) formed on a surface (10a) thereof; a heat collecting section (60) that collects infrared rays (55) reflected by the infrared reflective film (20) on the surface (10a) of the light collecting mirror (10); a power generator (84) including a turbine (82) rotatable by steam generated by heat collected to the heat collecting section (60); and a solar cell panel (30) including a solar cell (32) located inside the light collecting mirror (10).

## Description

### TECHNICAL FIELD

The present invention relates to a solar light-heat hybrid power generation system, and specifically to a power generation system utilizing optical energy and thermal energy from sunlight.

The present application claims the benefit of priority based upon Japanese Patent Application No.2011-289109 filed on December 28, 2011, the entirety of which is incorporated herein by reference.

### BACKGROUND ART

Recently, as the global environmental problem and the problem of energy exhaustion caused by increase in fossil fuel consumption or the like have become increasingly serious, clean energy which does not accompany much fossil fuel consumption has been desired. In addition, there is an increasing tendency of avoiding dependence on nuclear power generation in consideration of the influence of the Great East Japan Earthquake. In such a situation, power generation utilizing solar energy has been spread and is attracting more and more attention.

Power generation systems utilizing solar energy are roughly classified into solar light power generation systems and solar heat power generation systems (see, for example,

Patent Documents 1 and 2). According to a solar light power generation system which has been put into practice, a solar cell panel is installed on a roof of a house to generate power consumed by the household. According to a known solar heat power generation system, solar heat used as a heat source is converted into electric energy by a thermoelectric transducer having the Seebeck effect to generate power.

However, the solar light power generation systems have problems that the solar energy has a low energy density at a surface of the earth and is easily influenced by the weather conditions, daylight hours or the like. Namely, there is a problem that it is difficult to stably provide power due to the influences of these factors. The solar heat power generation systems utilizing a thermoelectric transducer have a problem that the currently known thermoelectric transducers have low performance and it is difficult to provide a sufficiently high power generation efficiency.

### CITATION LIST

### PATENT DOCUMENT

Patent Document 1: Japanese Patent Laid-Open Publication No. 2007-81097
Patent Document 2: Japanese Patent Laid-Open Publication No. 2001-7412

### SUMMARY OF THE INVENTION

### TECHNICAL PROBLEM

Patent Document 1 proposes a solar light-heat hybrid module capable of efficiently utilizing solar energy. Specifically, the proposed module is a combination of a solar cell panel and a thermal power generation device including a thermoelectric transducer that converts thermal energy of sunlight into electric energy. With this solar light-heat hybrid module, the problem of solar light power generation that the power generation efficiency is easily influenced by conditions such as cloudy weather, nighttime and the like can be compensated for by the thermal power generation device, and the problem of solar heat power generation that the power generation efficiency of the thermoelectric transducer itself is not sufficiently high can be compensated for by the solar cell panel. Patent Document 1 describes that in the cloudy weather or at nighttime, the solar light-heat hybrid module stably provides an amount of power that is about 5 to 15% larger than the power provided by a mere solar cell panel.

However, with the solar light-heat hybrid module described in Patent Document 1, the solar heat power generation is performed by use of the thermoelectric transducer. Therefore, the amount of power generated by the solar heat power generation is not very large. The technology described in Patent Document 1 merely compensates for the disadvantage of the solar cell panel for home or office use. Today, it is required to, rather than building new nuclear plants, provide a solar energy technology that can provide the amount of power which would be provided by such newly built nuclear plants. It is difficult for the technology described in Patent Document 1 to fulfill such a requirement.

In such a situation, the present inventor made active studies on technologies suitable for a large scale solar light-heat hybrid power generation system and achieved the present invention. The present invention made in light of the above-described points has a main object of providing a solar light-heat hybrid power generation system having an improved efficiency.

### SOLUTION TO THE PROBLEM

A solar light-heat hybrid power generation system according to the present invention is a solar light-heat hybrid power generation system that performs power generation by use of sunlight and solar heat and includes a light collecting mirror having an infrared reflective film formed on a surface thereof; a heat collecting section that collects infrared rays reflected by the infrared reflective film on the surface of the light collecting mirror; a power generator including a turbine rotatable by steam generated by heat collected to the heat collecting section; and a solar cell panel including a solar cell located inside the light collecting mirror.

In a preferable embodiment, the infrared reflective film transmits at least a part of light in a range from visible light to ultraviolet light toward the solar cell; and a substrate forming a surface of the solar cell panel is the surface of the light collecting mirror.

In a preferable embodiment, the substrate forming the surface of the solar cell panel is a glass substrate; and the solar cell panel includes a plurality of the solar cells arranged therein.

In a preferable embodiment, the heat collecting section is a heat collecting tube in which a liquid passes; the surface of the light collecting mirror is curved so that the reflected infrared rays are collected to the heat collecting tube; and a pipe extending from the heat collecting tube is connected to the turbine.

In a preferable embodiment, the heat collecting section is a heat collecting tube in which a liquid passes; and the light collecting mirror is a Fresnel-type mirror.

In a preferable embodiment, the heat collecting section is a heat collecting device installed on top of a tower; and the light collecting mirror includes a plurality of reflective mirrors arranged so as to collect light toward the heat collecting device.

In a preferable embodiment, the light collecting mirror is a parabola reflective mirror; and the heat collecting section is a heat collecting device located at a focal point of the parabola reflective mirror.

In a preferable embodiment, the power generator is located in the heat collecting device.

In a preferable embodiment, the infrared reflective film includes a resin substrate formed of a resin selected from the group consisting of polycarbonate, polyethylene terephthalate, poly(vinyl butyral), and an acrylic resin; and the resin substrate has a multi-layer film having wavelength selectivity formed thereon.

In a preferable embodiment, the infrared reflective film is a protective member that protects the surface of the light collecting mirror.

A light collecting mirror according to the present invention is a light collecting mirror usable in a solar light-heat hybrid power generation system, wherein the light reflective mirror has an infrared reflective film formed on a surface thereof; the light reflective mirror accommodates a solar cell therein; and the infrared reflective film transmits at least a part of light in a range from visible light to ultraviolet light toward the solar cell.

### ADVANTAGEOUS EFFECTS OF INVENTION

The solar light-heat hybrid power generation system according to the present invention can perform solar heat power generation by rotating the turbine by use of steam generated by the heat of infrared rays which is reflected by the infrared reflective film formed on the surface of the light collecting mirror. In addition, the solar light-heat hybrid power generation system according to the present invention can perform solar light power generation by the solar cell located inside the light collecting mirror by use of light transmitted through the infrared reflective film formed on the surface of the light collecting mirror. Therefore, the solar light-heat hybrid power generation system according to the present invention has an improved efficiency as compared with power generation by use of only solar light or power generation by use of only solar heat. Unlike a solar light-heat hybrid power generation system which performs solar heat power generation by use of a thermoelectric transducer and thus does not have a high efficiency, the solar light-heat hybrid power generation system according to the present invention performs power generation by rotating a turbine and thus is suitable for large scale power generation. Therefore, the power generation system according to the present invention can easily act as a power plant. In the case of being installed in a large estate in a regional district having long daylight hours, the solar light-heat hybrid power generation system according to the present invention has an improved efficiency without changing the size of the installation area.

### BRIEF DESCRIPTION OF THE DRAWINGS

[FIG. 1] FIG. 1 is a schematic view showing a structure of a solar light-heat hybrid power generation system 100 in an embodiment according to the present invention.
[FIG. 2] FIG. 2 is a partial cross-sectional view showing a structure of a light collecting mirror 10 in an embodiment according to the present invention.
[FIG. 3] FIG. 3 is a graph showing the relationship between the wavelength of light and the number of photons.
[FIG. 4] FIG.4 is a graph showing the spectral transmittance of an infrared reflective film 20 in an embodiment according to the present invention.
[FIG. 5] FIG. 5 is a schematic view showing a structure of a solar light-heat hybrid power generation system 100 in an embodiment according to the present invention.
[FIG. 6] FIG. 6 is a schematic view showing a structure of a solar light-heat hybrid power generation system 100 in an embodiment according to the present invention.
[FIG. 7] FIG. 7 is a schematic view showing a structure of a solar light-heat hybrid power generation system 100 in an embodiment according to the present invention.

### DESCRIPTION OF EMBODIMENTS

Hereinafter, preferable embodiments of the present invention will be described with reference to the drawings. Elements which are other than elements specifically referred to in this specification and are necessary to carry out the present invention may be grasped as a matter of design choice for a person of ordinary skill in the art based on the conventional technology in this field. The present invention can be carried out based on the contents disclosed by this specification and the attached drawings, and the technological common knowledge in the art.

In the figures referred to below, members or portions having the same functions bear the same reference signs and descriptions thereof may be omitted or simplified. In the figures, the relative sizes (length, width, thickness, etc.) do not necessarily reflect the actual relative sizes. In the drawings, hatching is mainly provided in order to make the elements easier to be grasped and does not necessarily represent materials. The present invention is not limited to the following embodiments in any way.

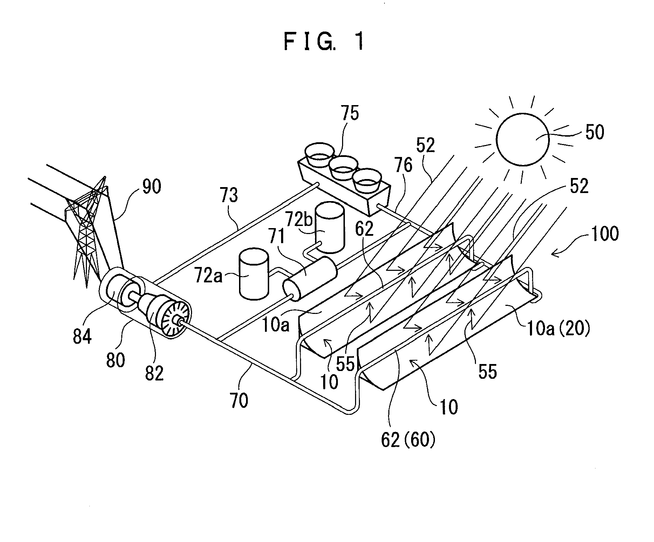

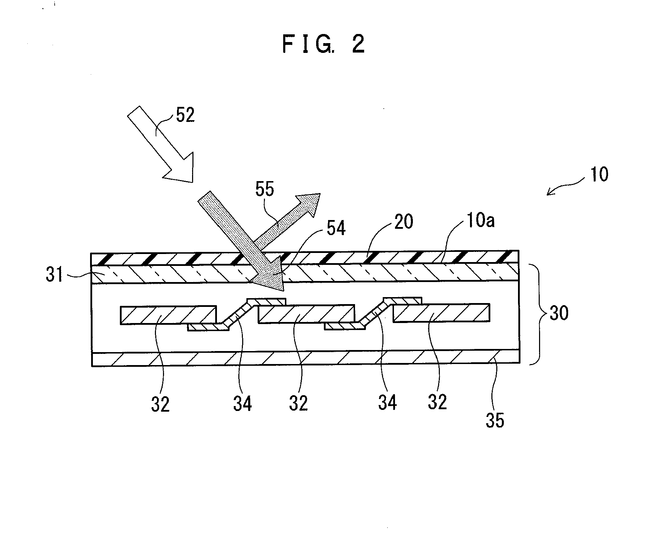

With reference to FIG. 1 and FIG. 2, an embodiment of the present invention will be described. FIG. 1 shows a structure of a solar light-heat hybrid power generation system 100 in an embodiment according to the present invention. The solar light-heat hybrid power generation system 100 shown in FIG. 1 is a power generation system that performs power generation by use of sunlight and solar heat (hereinafter, may be referred to as a "power generation system"). FIG. 2 shows a cross-sectional structure of a light collecting mirror 10 in the power generation system 100 in this embodiment.

As shown in FIG. 1, the power generation system 100 in this embodiment includes light collecting mirrors 10 and heat collecting sections 60 that collect light reflected by the light collecting mirrors 10. According to the structure of this embodiment, as shown in FIG. 2, each of the light collecting mirrors 10 has an infrared reflective film 20 formed on a surface thereof. The light collecting mirror 10 accommodates solar cells 32 therein. The solar cells 32 are formed of a semiconductor material; specifically, a silicon-based semiconductor (e.g., amorphous silicon, single crystalline silicon, polycrystalline silicon, etc.), a compound semiconductor (e.g., gallium arsenide-based semiconductor, indium gallium arsenide-based semiconductor, CIS-based (copper indium selenide-based) semiconductor, etc.), or an organic semiconductor material (e.g., dye-sensitized semiconductor material, organic thin film-type (conductive polymer or fullerene) semiconductor material, etc.).

According to the structure of this embodiment, the solar cells 32 are each provided as a part of a solar cell panel 30. In this example, the solar cell panel 30 includes a light-transmissive substrate (glass substrate) 31 at a front surface thereof. The substrate 31 of the solar cell panel 30 forms a surface 10a of the light collecting mirror 10. Namely, the infrared reflective film 20 is formed on the front substrate 31 of the solar cell panel 30.

The solar cell panel 30 includes a rear substrate 35 facing the front substrate 31. The rear substrate 35 is formed of, for example, a resin substrate (back sheet) or a metal material (e.g., aluminum, iron, stainless steel, etc.). The front substrate 31 and the rear substrate 35 form a casing in which the solar cells 32 are accommodated. In the solar cell panel 30, the plurality of solar cells 32 are connected to each other via lines 34. In actuality, the solar cells 32 are arranged two-dimensionally in accordance with a surface shape of the light collecting mirror 10.

In this embodiment, the infrared reflective film 20 reflects infrared rays (e.g., near infrared rays having a wavelength of 750 to 2500 nm) (see arrow 55) and transmits non-reflected light (e.g., at least a part of light in the range from visible light to ultraviolet light) (see arrow 54). The light transmitted through the infrared reflective film 20 reaches the solar cells 32 in the solar cell panel 30, and the solar cells 32 perform solar light power generation. In this embodiment, the infrared reflective film 20 has a thickness of, for example, 20 µm to 200 µm. In an example, the infrared reflective film 20 has a thickness of about 50 µm.

As shown in FIG. 1, the light (infrared rays) 55 reflected by the infrared reflective films 20 is directed toward the heat collecting sections 60. In this embodiment, the surface 10a of each light collecting mirror 10 is curved so that the reflected infrared rays 55 are collected to the heat collecting sections 60. The light collecting mirrors 10 shown in FIG. 1 are each a trough-type mirror, which has a groove shape extending in a longitudinal direction. In this embodiment, the heat collecting sections 60 are each a heat collecting tube 62 in which a liquid (e.g., oil, water, etc.) passes. The light (infrared rays) 55 reflected by the light collecting mirrors (trough-type mirrors) 10 is directed toward the heat collecting tubes 62 and thus heats the liquid (oil or water) in the heat collecting tubes 62.

In this embodiment, the heat collecting tubes 62 are connected to a pipe 70. The pipe 70 extending from the heat collecting tubes 62 is connected to a turbine 82. The turbine 82 is rotatable by steam generated by heat collected by the heat collecting tubes 62. The steam that rotates the turbine 82 may be steam generated by the heat collecting tubes 62 or steam generated by further heating the liquid heated by the heat collecting tubes 62. Alternatively, another liquid may be heated by the heat of the medium (liquid, steam) heated by the heat collecting tubes 62, and the resultant steam may be used to rotate the turbine 82. Still alternatively, the liquid heated by the heat collecting tubes 62 may be further heated into steam, which may be used to rotate the turbine 82. The liquid (heat transmitting medium) flowing in the heat collecting sections 60 (heat collecting tubes 62) and the pipe 70 is not limited to water, oil or the like and may be melt salt or the like.

In this embodiment, the turbine 82 is coupled to a power generator 84. A solar heat power generation unit 80 including the turbine 82 and the power generator 84 performs solar heat power generation. The power generated by the solar heat power generation unit 80 is supplied to plants or households via power lines 90. The steam used by the turbine 82 is transmitted to a condenser 75 via a pipe (exhaust steam pipe) 73. The liquid condensed by the condenser 75 can be returned to the heat collecting tubes 62 via a pipe (liquid supply pipe) 76.

The liquid (or steam) heated by the heat collected by the heat collecting tubes 62 can be stored in a heat storage tank 72a via the pipe 70. The heat of the liquid (or heat storing material) in the heat storage tank 72a can be supplied toward the turbine 82 by use of a pump 71. In addition, according to the structure of this embodiment, a liquid supply tank 72b is provided. The liquid in the liquid supply tank 72b can be supplied to the heat collecting tubes 62 via the pipe (liquid supply pipe) 76 by use of the pump 71. In order to uniformize the amount of power generated throughout a day, solar light power generation may be mainly performed during the daytime, whereas solar heat power generation may be mainly performed during the nighttime by use of the heat of the liquid or the heat storage material in the heat storage tank 72a.

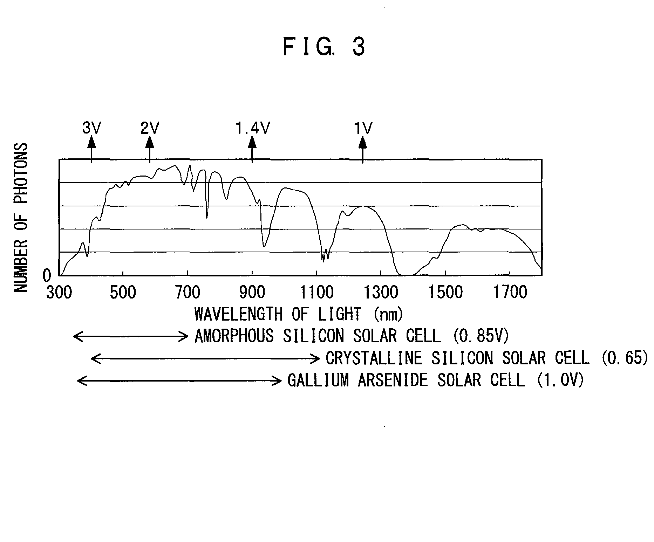

Owing to light 52 of the sun 50, energy of 1 kilowatt (1 kW) per square meter (1 m²) is provided to the surface of the earth. As shown in FIG. 3, the energy ranges from a visible light range (350 nm to 700 nm) to an infrared range. The wavelength of light is related to a generated voltage. For example, a voltage of 1.4 V can be generated by light of about 900 nm. FIG. 3 also shows wavelength ranges of light usable by typical solar cells.

As can be understood from FIG. 3, a part of the light in the infrared range having a wavelength of 700 nm or longer is not utilized, and energy of such unutilized light is abolished by solar light power generation. By the solar light-heat hybrid power generation system 100 in this embodiment, the energy which is not utilized by solar light power generation is utilized for solar heat power generation. Thus, the efficiency of the solar light-heat hybrid power generation system 100 is improved as compared with that of a mere solar light power generation system.

In this embodiment, the infrared reflective film 20 includes a resin substrate formed of a light-transmissive resin material (e.g., polycarbonate) and a multi-layer film having wavelength selectivity formed on the resin substrate. Specifically, the infrared reflective film 20 is formed by depositing a multi-layer film mainly containing titanium oxide and silver and having a thickness of about 0.3 µm on a polycarbonate substrate by sputtering.

The resin substrate is not limited to being formed of polycarbonate and may be formed of another material (e.g., polyethylene terephthalate, poly(vinyl butyral), acrylic resin such as poly(methyl methacrylate) or the like, etc.). The infrared reflective film 20 is not limited to being formed of any of the above-described materials and may be formed of any of a variety of types of films that can reflect infrared rays and transmit light of a wavelength which can be utilized for solar power generation performed by solar cells 32.

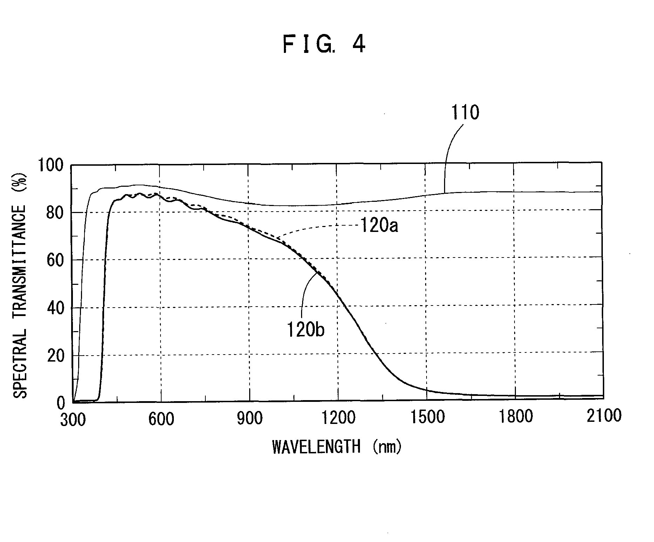

FIG. 4 shows the spectral transmittance of an example of the infrared reflective film 20 in this embodiment. In FIG. 4, line 110 represents the spectral transmittance obtained in the absence of the infrared reflective film 20. In FIG. 4, line 120a represents the spectral transmittance obtained when light is transmitted through the infrared reflective film 20 before the infrared reflective film 20 is subjected to a light stability test, and line 120b represents the spectral transmittance obtained when light is transmitted through the infrared reflective film 20 after the infrared reflective film 20 is subjected to the light stability test.

As shown in FIG. 4, in the absence of the infrared reflective film 20 (line 110), light in the infrared range is transmitted. By contrast, in the presence of the infrared reflective film 20 (line 120a, line 120b), the transmittance of light in the ultraviolet and visible light ranges is high whereas the transmittance of light in the infrared range is low. A part of, or the entirety of, the light in the infrared range is reflected by the infrared reflective film 20. In addition, the infrared reflective film 20 in this embodiment shows substantially the same spectral transmittance before and after being subjected to the light stability test, and thus can reflect infrared rays even when being actually used in the solar light-heat hybrid power generation system 100.

In this embodiment, the infrared reflective film 20 may be formed by bonding a film having a function of reflecting infrared rays (e.g., film including a resin film as a substrate) to the surface 10a of the light collecting mirror 10. Alternatively, a material to be used for the infrared reflective film 20 may be applied to the surface 10a of the light collecting mirror 10, so that the infrared reflective film 20 is formed of the material. Still alternatively, the light collecting mirror 10 having the infrared reflective film 20 in this embodiment formed on the surface 10a thereof may be mounted as an element of the solar light-heat hybrid power generation system 100. Still alternatively, after the light collecting mirror 10 is installed, the infrared reflective film 20 may be formed on the surface 10a of the light collecting mirror 10. Still alternatively, after a substrate used to form the infrared reflective film 20 is formed on the surface 10a of the light collecting mirror 10, a functional film having wavelength selectivity (in the above-described example, the multi-layer film) may be formed on the substrate.

According to the structure of this embodiment, the surface 10a of each light collecting mirror 10 (or the front substrate of the solar cell panel) is formed of the glass substrate 31. Therefore, the infrared reflective film 20 can act as a protective member (protective sheet) that protects the glass substrate 31. Specifically, the infrared reflective film 20 can protect the glass substrate 31 against breakage. Even when the glass substrate 31 is broken and pieces thereof are scattered, the infrared reflective film 20 can prevent the broken pieces of the glass substrate 31 from scattering outside.

The surface 10a of each light collecting mirror 10 (or the front substrate of the solar cell panel) may be formed of a resin substrate (e.g., resin substrate formed of an engineering plastic material) instead of the glass substrate 31. Even in this case, the infrared reflective film 20 can protect the resin substrate which forms the surface 10a of the light collecting mirror 10.

In this embodiment, the infrared reflective film 20 reflects infrared rays (55) of the sunlight 52, and therefore, can suppress temperature rise of the solar cells 32. The power generation efficiency of the solar cells 32 tends to be decreased by heat. However, the infrared reflective film 20 can suppress the temperature rise, which increases the efficiency of solar light power generation. In the case where a cooling device is used in order to suppress the temperature rise of the solar cells 32, the cooling device may be replaced with a lower performance device. This contributes to cost reduction.

According to the structure shown in FIG. 2, the surface 10a of each light collecting mirror 10 is the same as the front substrate 31 of the solar cell panel 30. The present invention is not limited to such a structure. A member forming the surface 10a of the light collecting mirror 10 (light-transmissive substrate) and the front substrate 31 of the solar cell panel may be formed separately, and then located to overlap each other. In this case, the light collecting mirror 10 may be first installed and then the solar cell panel 30 may be installed to the rear of the light collecting mirror 10. By contrast, the solar cell panel 30 may be first installed and then the light collecting mirror 10 may be installed to the front of the solar cell panel 30.

The solar light-heat hybrid power generation system 100 in this embodiment can reflect the infrared rays 55 of the sunlight 52 by use of the infrared reflective film 20 formed on the surface 10a of each light collecting mirror 10. A liquid is heated by the heat of the reflected infrared rays 55, and steam generated from the heated liquid is used to rotate the turbine 82, so that the solar heat power generation unit 80 performs solar heat power generation. In the meantime, the light 54 transmitted through the infrared reflective film 20 formed on the surface 10a of each light collecting mirror 10 can be used to perform solar light power generation by use of the solar cells 32 located inside the light collecting mirror 10. Therefore, the solar light-heat hybrid power generation system 100 has a higher efficiency than that of a mere solar light power generation system or a mere solar heat power generation system.

The solar light-heat hybrid power generation system described in Patent Document 1, which uses a thermoelectric transducer for solar heat power generation, has performance thereof limited by the low efficiency of the thermoelectric transducer and is not suitable for large scale power generation facilities. By contrast, the solar light-heat hybrid power generation system 100 in this embodiment, which generates power by rotating the turbine 82, is suitable for large scale power generation and therefore easily acts as a power plant. In addition, the solar light-heat hybrid power generation system 100 in this embodiment may be operated together with a thermal power plant or a gas turbine, and thus may be possibly used in combination with an existing power plant.

In the case where the solar light-heat hybrid power generation system 100 in this embodiment is installed in a large estate in a regional district having long daylight hours, solar light power generation can be performed with the same size of area as that of a mere solar heat power generation system. Thus, the solar light-heat hybrid power generation system 100 is efficient also in terms of equipment cost. Specifically, the solar light-heat hybrid power generation system 100 in this embodiment can be realized merely by providing the light collecting mirror 10, the infrared reflective film 20 and the solar cell panel 30 in addition to the reflective mirror of a mere solar heat power generation system. Therefore, the structure of this embodiment may be possibly used as being added to an existing mere solar heat power generation system.

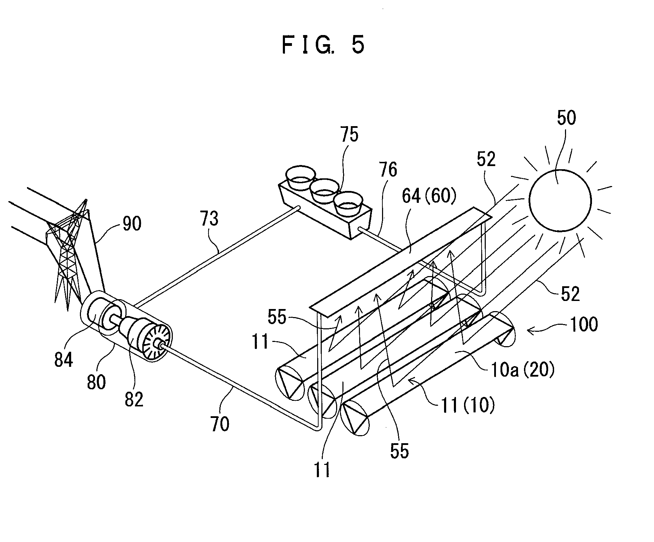

Now, with reference to FIG. 5 through FIG. 7, modifications of this embodiment will be described. The same contents as those described above will not be repeated.

### (Modification 1)

A solar light-heat hybrid power generation system 100 shown in FIG. 5 is of a Fresnel type. Specifically, the light collecting mirrors 10 in this modification are Fresnel-type mirrors 11. Whereas the surface 10a of each light collecting mirror 10 shown in FIG. 1 is curved, the light collecting mirrors 10 shown in FIG. 5 (Fresnel-type mirrors 11) each have a substantially flat surface 10a. Each Fresnel-type mirror 11 has a groove (not shown) formed therein so that the reflected infrared rays 55 are collected to a heat collecting tube 64 acting as the heat collecting section 60. In this example, the heat collecting tube 64 is plate-shaped.

In this structural example, the above-described infrared reflective film 20 is formed on the surface 10a of each Fresnel-type mirror 11 having the groove formed therein, so that the infrared rays 55 can be separated from the ultraviolet and visible light 54. Alternatively, the infrared reflective film 20 may have a groove formed therein so that the Fresnel-type mirror 11 is formed of this part of the infrared reflective film 20. As shown in FIG. 2, the solar cell panel 30 including the solar cells 32 is located to the rear of the surface 10a of the Fresnel-type mirror 11.

The Fresnel-type mirrors 11 shown in FIG. 5, each of which has the substantially flat surface 10a, have an advantage of reflecting the light 52 of the sun 50 wherever the sun 50 may be located in a wide range of area, namely, even when the sun 50 moves. For example, with the structure shown in FIG. 1, it is advantageous in the north hemisphere to direct the surface 10a of each light collecting mirror 10 southward. However, the light 52 of the sun 50 may not be reflected efficiently depending on the time of the day. With the structure shown in FIG. 5, in the state where the surface 10a of each Fresnel-type mirror 11 is substantially parallel to the surface of the earth, the influence of the position of the sun 50 can be alleviated. Needless to say, the surface 10a of the Fresnel-type mirror 11 may be inclined to be directed, for example, southward instead of being substantially parallel to the surface of the earth. The power generation system 100 described in this example can be combined with a thermal power plant to provide a hybrid power generation system.

### (Modification 2)

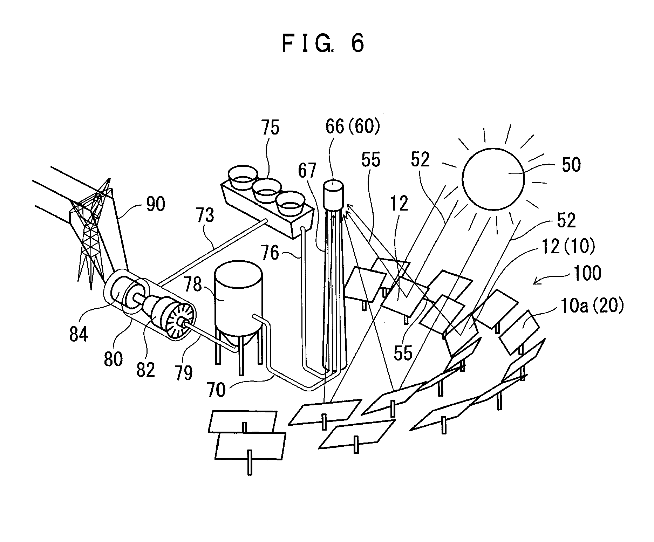

A solar light-heat hybrid power generation system 100 shown in FIG. 6 is of a tower-type. According to the structure of this modification, the heat collecting section 60 is a heat collecting device 66 provided on top of a tower (e.g., pylon), and the light collecting mirrors 10 are a plurality of reflective mirrors 12 located such that light is collected toward the heat collecting device (light collecting device) 66. Each reflective mirror 12 has the infrared reflective film 20 formed on a surface 10a thereof. As shown in FIG. 2, the solar cell panel 30 including the solar cells 32 is located to the rear of the surface 10a of the reflective mirror 12.

In this example, a Heliostat system, by which each reflective mirror 12 is a plane mirror and light reflected by the reflective mirrors 12 is caused to overlap each other at one point for light collection, is used. Preferably, each reflective mirror 12 includes a mechanism that adjusts the orientation of the mirror in accordance with the movement of the sun. For example, in the case where several hundred to several thousand reflective mirrors 12 each having a size of several meters square are used to concentrate the reflective light 55 at one position in the light collecting device 66, the light can be heated to about 1000°C.

In the power generation system 100 shown in FIG. 6, the liquid (oil, water, melted salt, etc.) is supplied to the heat collecting device 66 via the pipe 76, and is heated by the heat collecting device 66. The heated liquid is transmitted to a bottom part of a tower 67 via the pipe 70. The solar heat power generation unit 80 performs power generation by vaporizing water and thus rotating the steam turbine 82. In this example, a supplied water re-heating device 78 is provided, so that high temperature heat can be stored. Namely, heat may be stored during the daytime by use of the supplied water re-heating device (or heat regenerator) 78 so that power generation can be performed also at nighttime. The power generation system 100 described in this example can be combined with a thermal power plant to provide a hybrid power generation system.

### (Modification 3)

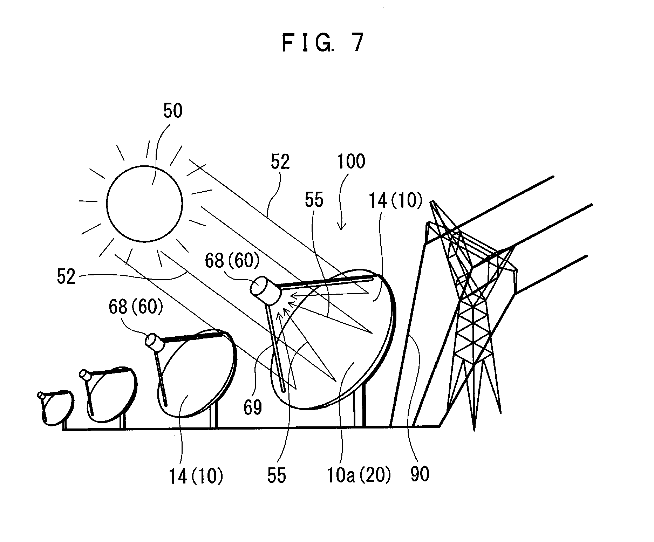

A solar light-heat hybrid power generation system 100 shown in FIG. 7 is of a dish-type. According to the structure of this modification, the light collecting mirrors 10 are parabola reflective mirrors 14 each having a paraboloidal surface, and the heat collecting sections 60 are heat collecting devices 68 each located at a focal point of the corresponding parabola reflective mirror 14. The heat collecting sections 60 shown in the figure are each secured by support sections (support rods) 69 extending from ends of the corresponding parabola reflective mirror 14. Each parabola reflective mirror 14 has the infrared reflective film 20 formed on a surface 10a thereof. As shown in FIG. 2, the solar cell panel 30 including the solar cells 32 is located to the rear of the surface 10a of the parabola reflective mirror 14.

The power generation system 100 shown in FIG. 7 can generate steam by use of the heat of the heat collecting devices 68. For example, the power generation may be performed by a turbine located apart from the parabola reflective mirrors 14, or a power generator may be located in each heat collecting device 68. The power generator does not need to have a turbine. A power generator having a Stirling engine may be mounted on each heat collecting device 68 to perform solar heat power generation. A Stirling engine is an external combustion engine which obtains work by externally heating or cooling gas (or air, etc.) in a cylinder. In this example, the Stirling engine uses the heat of the heat collecting device 68 as a heat source. The parabola reflective mirrors 14 may each have a mechanism that adjusts the orientation of the mirror in accordance with the movement of the sun.

So far, the present invention has been described by way of preferable embodiments. The present invention is not limited to the above descriptions and may be carried out in any of various modifications, needless to say. For example, the solar cells 32 in this embodiment may have a stack structure in which a plurality of solar cells using different wavelength ranges are stacked in layers in order to make effective use of the light 54 transmitted through the infrared reflective film 20. For example, the solar cells 32 may include a stack of microcrystalline silicon and amorphous silicon. Alternatively, the solar cells 32 may include a stack of amorphous silicon (a-Si) and a-SiC or a-SiGe having a different bandgap from that of a-Si. The solar cell panel 30 may be formed of a flexible material so as to be shaped in conformity to the shape of the light collecting mirror (reflective mirror) 10. The elements in the above-described embodiments and modifications may be combined together in various manners.

The infrared reflective film 20 formed on a surface of each light collecting mirror 10 is, for example, bonded to the light collecting mirror 10 with an adhesive. A preferable adhesive has an adhesive force at which the infrared reflective film 20 is not peeled off in a natural state. Specifically, the adhesive may be formed of, or contain as a main component, any of known resins such as natural rubber, stylene-butadiene copolymerizable rubber, polyisobutylene, acrylic resin, polyvinylether, polyvinylisobutylether or the like. Among these resins, an acrylic resin having a glass transition temperature (Tg) of -10°C to -60°C such as poly(butyl acrylate), poly-2-ethylhexylacrylate or the like is preferable. A tackifier such as rosin, rosin ester, coumarone resin, terpene resin, hydrocarbon resin or oil-soluble phenol resin is optionally used with the above-described resin. A softener such as fatty acid ester, animal and vegetable oil and fat, wax, or heavy petroleum distillate is optionally used with the above-described resin depending on the compatibility thereof with the resin.

### INDUSTRIAL APPLICABILITY

The present invention provides a solar light-heat hybrid power generation system having an improved efficiency.

### DESCRIPTION OF REFERENCE SIGNS

- 10: Light collecting mirror
- 11: Fresnel-type mirror
- 12: Reflective mirror
- 14: Parabola reflective mirror
- 20: Infrared reflective film
- 30: Solar cell panel
- 31: Front substrate (glass substrate)
- 32: Solar cell
- 34: Line
- 35: Rear substrate
- 50: Sun
- 52: Sunlight (solar heat)
- 54: Transmitted light (ultraviolet and visible light)
- 55: Reflected light (infrared rays)
- 60: Heat collecting section
- 62: Heat collecting tube
- 64: Heat collecting tube
- 66: Heat collecting device
- 67: Tower
- 68: Heat collecting device
- 70: Pipe
- 71: Pump
- 72a: Heat storage tank
- 72b: Liquid supply tank
- 75: Condenser
- 76: Pipe
- 78: Supplied water re-heating device
- 80: Solar heat power generation unit
- 82: Turbine (steam turbine)
- 84: Power generator
- 90: Power line
- 100: Solar light-heat hybrid power generation system

## Claims

1. A solar light-heat hybrid power generation system that performs power generation by use of sunlight and solar heat, the solar light-heat hybrid power generation system comprising:
a light collecting mirror having an infrared reflective film formed on a surface thereof;
a heat collecting section that collects infrared rays reflected by the infrared reflective film on the surface of the light collecting mirror;
a power generator including a turbine rotatable by steam generated by heat collected to the heat collecting section; and
a solar cell panel including a solar cell located inside the light collecting mirror.

2. The solar light-heat hybrid power generation system according to claim 1, wherein:
the infrared reflective film transmits at least a part of light in a range from visible light to ultraviolet light toward the solar cell; and
a substrate forming a surface of the solar cell panel is the surface of the light collecting mirror.

3. The solar light-heat hybrid power generation system according to claim 2, wherein:
the substrate forming the surface of the solar cell panel is a glass substrate; and
the solar cell panel includes a plurality of the solar cells arranged therein.

4. The solar light-heat hybrid power generation system according to any one of claims 1 through 3, wherein:
the heat collecting section is a heat collecting tube in which a liquid passes;
the surface of the light collecting mirror is curved so that the reflected infrared rays are collected to the heat collecting tube; and
a pipe extending from the heat collecting tube is connected to the turbine.

5. The solar light-heat hybrid power generation system according to any one of claims 1 through 3, wherein:
the heat collecting section is a heat collecting tube in which a liquid passes; and
the light collecting mirror is a Fresnel-type mirror.

6. The solar light-heat hybrid power generation system according to any one of claims 1 through 3, wherein:
the heat collecting section is a heat collecting device installed on top of a tower; and
the light collecting mirror includes a plurality of reflective mirrors arranged so as to collect light toward the heat collecting device.

7. The solar light-heat hybrid power generation system according to any one of claims 1 through 3, wherein:
the light collecting mirror is a parabola reflective mirror; and
the heat collecting section is a heat collecting device located at a focal point of the parabola reflective mirror.

8. The solar light-heat hybrid power generation system according to claim 7, wherein the power generator is located in the heat collecting device.

9. The solar light-heat hybrid power generation system according to any one of claims 1 through 8, wherein:
the infrared reflective film includes a resin substrate formed of a resin selected from the group consisting of polycarbonate, polyethylene terephthalate, poly(vinyl butyral), and an acrylic resin; and
the resin substrate has a multi-layer film having wavelength selectivity formed thereon.

10. The solar light-heat hybrid power generation system according to any one of claims 1 through 9, wherein the infrared reflective film is a protective member that protects the surface of the light collecting mirror.

11. A light collecting mirror usable in a solar light-heat hybrid power generation system, wherein:
the light reflective mirror has an infrared reflective film formed on a surface thereof;
the light reflective mirror accommodates a solar cell therein; and
the infrared reflective film transmits at least a part of light in a range from visible light to ultraviolet light toward the solar cell.
